# EUROPEAN PATENT APPLICATION

(11) **EP 1 753 232 A1**
(43) Date of publication of application: **14.02.2007**
(21) Application number: 06118840.5
(22) Date of filing: 11.08.2006
(51) Int. Cl.: H04N 5/44, H04B 1/06

(54) **Terrestrial-digital multimedia broadcasting and digital audio broadcasting low intermediate frequency receiver**

(30) Priority: 13.08.2005 KR 20050074552
(71) Applicant: Integrant Technologies Inc., Seongnam-si, Gyoenggi-do 463-810 (KR)
(72) Inventor: Kim, Bonkee Mokryeon Maeul Yeongnam Apt. 502-603, Seongnam-si, Gyeonggi-do (KR); Kim, Bo-Eun Sejong Lizencivil 207-103, Yongin-si, Gyeonggi-do (KR)
(74) Representative: Joly, Jean-Jacques

(57) **Abstract**

Provided is a terrestrial-digital multimedia broadcasting (T-DMB) and digital audio broadcasting (DAB) low intermediate frequency (IF) receiver. A T-DMB and DAB low IF receiver comprises a low noise amplifier (LNA) 202, an image rejection down-conversion mixer 203, a low pass filter 204, an amplifier 205, a local oscillator 208, and a phase-locked loop 209. Particularly, the LNA, the image rejection down-conversion mixer, the low pass filter, the amplifier, the local oscillator, and the phase-locked loop are integrated in a monolithic semiconductor integrated circuit substrate. Using the T-DMB and DAB low IF receiver allows a removal of a conventional SAW filter and the T-DMB and DAB low IF receiver can be easily integrated in the monolithic semiconductor integrated circuit substrate, and manufactured at low costs.

## Description

### BACKGROUND OF THE INVENTION

### Field of the Invention

The present invention relates to a terrestrial-digital multimedia broadcasting (T-DMB) and digital audio broadcasting (DAB) receiver.

### Description of the Background Art

A conventional receiver uses a super-heterodyne mode that converts a received signal into a signal at an intermediate frequency (IF) band and then into a signal at a baseband.

Generally, IF is used to improve the performance of the receiver using a filter that effectively filters a specific frequency band. A surface acoustic wave (SAW) filter is usually used as the aforementioned filter.

A conventional DAB receiver uses an L-band of the radio frequency (RF) spectrum ranging from 1,450 MHz to 1,492 MHz. On the other hand, a conventional T-DMB receiver uses a Band-III band of the RF spectrum ranging from 174 MHz to 245 MHz. Also, the conventional DAB and T-DMB receivers use an IF of 38.912 MHz and have a channel bandwidth of 1.536 MHz.

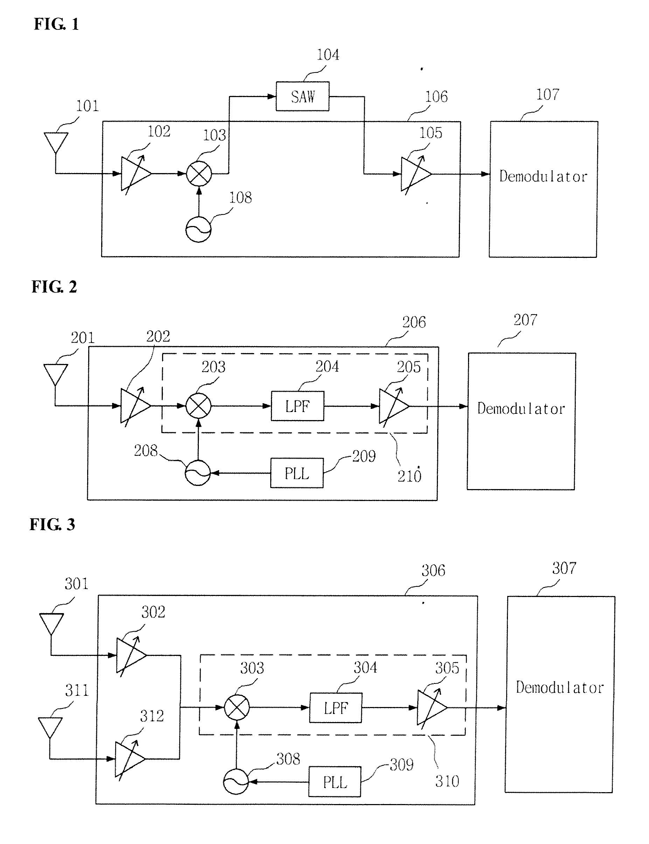

FIG. 1 illustrates a simplified block diagram of a conventional receiver.

A RF signal that is received by an antenna 101 is supplied to a low noise amplifier (LNA) 102. An output signal of the LNA 102 is transmitted to a mixer 103, which subsequently moves the transmitted signal to the IF band.

An output signal of the mixer 103 passes through a band-pass filter 104 and is transmitted to an amplifier 105. A demodulator 107 receives an output signal of the amplifier 105. A local oscillator 108 generates a frequency to make the received RF signal move to the IF band and, supplies the generated frequency to the mixer 103.

The band-pass filter 104 is a SAW filter that is generally used in the typical super-heterodyne mode.

The LNA 102, the mixer 103, the amplifier 105, and the local oscillator 108 are integrated into a single receiver chip 106, and the band-pass filter 104 (i.e., the SAW filter) is disposed outside the receiver chip 106.

The SAW filter is a filter for telecommunications using mechanical vibrations from a piezoelectric substrate. On the piezoelectric substrate, two slit patterned metal plates are arranged to face in opposite direction on both sides of the piezoelectric substrate. When an electric signal is inputted from one direction, a surface acoustic wave is generated on the piezoelectric substrate.

The surface acoustic wave, which is also called "mechanical vibration," is converted into an electric signal in the opposite direction to the input direction. If the surface acoustic wave of the piezoelectric substrate has a different frequency from the inputted electric signal, the signal transmission does not take place. As a result, the SAW filter functions as a band-pass filter that passes only a frequency identical to a mechanical-physical frequency of the SAW filter.

As compared with a filter using the LC resonance principle, the SAW filter generally passes a very narrow bandwidth, and thus, can be effective to select a desired signal frequency with a narrow bandwidth since the SAW filter can almost completely filter out unnecessary signal frequencies.

However, the SAW filter is a mechanical filter, and thus, often has a limitation in reducing the volume. As illustrated in FIG. 1, in the case that the receiver using the band-pass filter 104 (i.e., the SAW filter) is implemented in a single integration chip, the SAW filter usually cannot be integrated therein, thereby being placed outside the receiver chip 106.

Since the SAW filter is expensive, the total manufacturing cost for the receiver often increases.

Therefore, when such a receiver using the SAW filter is implemented to a mobile telecommunications terminal, the SAW filter may become a main factor that increases the price of the receiver. Also, it may be difficult to integrate the receiver into a single chip.

A receiver that receives a single RF signal by a single antenna can receive a single corresponding frequency band. Therefore, when at least two frequency bands need to be received, a number of receiver chips are necessary to receive the frequency bands individually. As a result, the overall volume of the telecommunications devices may increase, and the manufacturing costs may also increase.

### SUMMARY OF THE INVENTION

Accordingly, one embodiment of the present invention is directed to provide a T-DMB and DAB low IF receiver that can be easily integrated into a single chip and manufactured at low costs.

Another embodiment of the present invention is directed to provide a dual band T-DMB and DAB low IF receiver that can be easily integrated into a single chip and manufactured at low costs by receiving signals at two frequency bands.

A terrestrial-digital multimedia broadcasting (T-DMB) and digital audio broadcasting (DAB) low intermediate frequency (IF) receiver according to an embodiment of the present invention comprises a low noise amplifier (LNA) suppressing a noise signal of a received radio frequency (RF) signal and amplifying the received RF signal, wherein the received RF signal includes a T-DMB signal or a DAB signal, an image rejection down-conversion mixer converting a frequency band of the RF signal outputted from the LNA into a low IF band and rejecting an image frequency band, a low pass filter filtering a low frequency band of a signal outputted from the image rejection down-conversion mixer, an amplifier amplifying a signal outputted from the low pass filter, a local oscillator generating a frequency for the down-conversion and supplying the frequency to the image rejection down-conversion mixer, and a phase-locked loop moving the frequency of the local oscillator to a certain frequency and locking the certain frequency, wherein the LNA, the image rejection down-conversion mixer, the low pass filter, the amplifier, the local oscillator, and the phase-locked loop are integrated in a monolithic semiconductor integrated circuit substrate.

Consistent with the embodiment of the present invention, the RF signal of the LNA comprises a signal at one frequency band of a Band-III ranging between about 174 MHz and about 245 MHz or an L-band ranging between about 1,450 MHz and about 1,492 MHz.

Consistent with the embodiment of the present invention, the amplifier may output a signal having a center frequency ranging from about 0.768 MHz to about 0.960 MHz.

Consistent with the embodiment of the present invention, the LNA and the amplifier comprise one of a programmable gain amplifier and a variable gain amplifier.

A dual band terrestrial-digital multimedia broadcasting (T-DMB) and digital audio broadcasting (DAB) low intermediate frequency (IF) receiver according to another embodiment of the present invention comprises a first low noise amplifier (LNA) suppressing a noise signal of a received first radio frequency (RF) signal and amplifying the received first RF signal, wherein the received first RF signal includes a T-DMB signal, a second low noise amplifier (LNA) suppressing a noise signal of a received second radio frequency (RF) signal and amplifying the received second RF signal, wherein the received second RF signal includes a DAB signal, an image rejection down-conversion mixer converting frequency bands of the first and second RF signals respectively outputted from the first and second LNAs into a low IF band and rejecting an image frequency band, a low pass filter filtering a low frequency band of a signal outputted from the image rejection down-conversion mixer, an amplifier amplifying a signal outputted from the low pass filter, a local oscillator generating a frequency for the down-conversion and supplying the frequency to the image rejection down-conversion mixer, and a phase-locked loop moving the frequency of the local oscillator to a certain frequency and locking the certain frequency, wherein the first and second LNAs, the image rejection down-conversion mixer, the low pass filter, the amplifier, the local oscillator, and the phase-locked loop are integrated in a monolithic semiconductor integrated circuit substrate.

Consistent with the other embodiment of the present invention, the first RF signal of the first LNA may comprise a signal at a Band-III frequency band ranging between about 174 MHz and about 245 MHz; and the second RF signal of the second LNA may comprise a signal at an L-band frequency band ranging between about 1,450 MHz and about 1,492 MHz.

Consistent with the other embodiment of the present invention, the amplifier may output a signal having a center frequency ranging from about 0.768 MHz to about 0.960 MHz.

Consistent with the other embodiment of the present invention, the first and second LNAs and the amplifier may comprise one of a programmable gain amplifier and a variable gain amplifier.

### BRIEF DESCRIPTION OF THE DRAWINGS

The invention will be described in detail with reference to the following drawings in which like numerals refer to like elements.

FIG. 1 illustrates a simplified block diagram of a receiver using a conventional SAW filter;

FIG. 2 illustrates a simplified block diagram of a T-DMB and DAB low IF receiver according to an embodiment of the present invention; and

FIG. 3 illustrates a simplified block diagram of a dual band T-DMB and DAB low IF receiver according to an embodiment of the present invention.

### DETAILED DESCRIPTION OF EMBODIMENTS

Embodiments of the present invention will be described in a more detailed manner with reference to the drawings.

FIG. 2 illustrates a simplified block diagram of a T-DMB and DAB low IF receiver according to an embodiment of the present invention.

The receiver comprises an LNA 202, an image rejection down-conversion mixer 203, a low pass filter 204, an amplifier 205, a local oscillator 208, and a phase-locked loop 209. The receiver is particularly a T-DWB and DAB low IF receiver in which the LNA 202, the image rejection down-conversion mixer 203, the low pass filter 204, the amplifier 205, the local oscillator 208, and the phase-locked loop 209 are integrated into a single chip, i.e., a receiver chip 206.

An antenna 201 receives a RF signal and transmits the RF signal to the LNA 202 that suppresses a noise signal and amplifies the RF signal. An output signal of the LNA 202 is transmitted to the image rejection down-conversion mixer 203 that removes an image frequency component and performs a down-conversion of a frequency band of the RF signal into a low IF band.

The low pass filter 204 that filters a signal at a low frequency band receives an output signal of the image rejection down-conversion mixer 203. An output signal of the low pass filter 204 is transmitted to the amplifier 205, and the demodulator 207 receives an output signal of the amplifier 205.

The local oscillator 208 generates a frequency that allows the image rejection down-conversion mixer 203 to perform the down-conversion of the RF signal into the low IF signal. The generated frequency is provided to the image rejection down-conversion mixer 203. The phase-locked loop 209 supplies a signal to the local oscillator 208 to move and lock the frequency generated by the local oscillator 208.

According to the above-described configuration, the SAW filter can be removed from the receiver, and thus, the receiver can be manufactured at low costs and easily integrated into a single chip.

Also, the above-described receiver configuration allows the integration of the LNA 202, the image rejection down-conversion mixer 203, the low pass filter 204, the amplifier 205, the local oscillator 208, and the phase-locked loop 209 into the single receiver chip 206.

The T-DMB and DAB low IF receiver according to the embodiment of the present invention receives a range of frequencies at the Band-III of the frequency spectrum between about 174 MHz and about 245 MHz or at the L-band of the frequency spectrum between about 1,450 MHz and about 1,492 MHz.

Also, after receiving the aforementioned range of frequencies at the Band-III or L-band of the frequency spectrum, the T-DMB and DAB low IF receiver supplies a range of frequencies between about 0.768 MHz and about 0.960 MHz as a center frequency to an output terminal of the receiver.

A band width of the frequency at the output terminal of the receiver in the present embodiment is about 1.536 MHz.

A lower limit of the frequency at the output terminal of the receiver according to the embodiment of the present invention is about 0.768 MHz because a part of the frequency component at the output terminal of the receiver is likely to enter into a negative frequency region when the center frequency is about 0.768 MHz or less in the case that the band width of the frequency at the output terminal of the receiver is about 1.536 MHz.

In addition, according to the embodiment of the present invention, an upper limit of the center frequency at the output terminal of the receiver is about 0.960 MHz. The reason for setting the upper limit is because when the center frequency is about 0.960 MHz or more, undesired adjacent signals may also be comprised therein since the guard band has the minimum frequency of about 0.192 MHz or 0.176 MHz according to the specification set differently from country to country using a frequency resource.

Particularly, the output terminal of the receiver may have a center frequency of about 850 kHz.

The LNA 202 and the amplifier 205 may comprise a programmable gain amplifier or a variable gain amplifier. Although not illustrated, an automatic gain controller (AGC) adjusts amplification gains of the LNA 202 and the amplifier 205.

The demodulator 207 receives a signal from the output terminal of the receiver chip 206.

FIG. 3 illustrates a simplified block diagram of a dual band T-DMB and DAB low IF receiver according to an embodiment of the present invention.

The receiver comprises a first LNA 302, a second LNA 312, an image rejection down-conversion mixer 303, a low pass filter 304, an amplifier 305, a local oscillator 308, and a phase-locked loop 309. The receiver is particularly a dual band T-DMB and DAB low IF receiver in which the first and second LNAs 302 and 312, the image rejection down-conversion mixer 303, the low pass filter 304, the amplifier 305, the local oscillator 308, and the phase-locked loop 309 are integrated into a single chip, i.e., a receiver chip 306.

A first antenna 301 receives a first RF signal and transmits the first RF signal to the first LNA 302 that suppresses a noise signal and amplifies the first RF signal. A second antenna 311 receives a second RF signal and transmits the second RF signal to the second LNA 312 that suppresses a noise signal and amplifies the second RF signal.

An output signal of the first LNA 302 and an output signal of the second LNA 312 are transmitted to the image rejection down-conversion mixer 303 that removes an image frequency component and performs the down-conversion of a frequency band pertained to each of the first and second RF signals into a low IF band.

The low pass filter 304 that filters a signal at a low frequency band receives an output signal of the image rejection down-conversion mixer 303. An output signal of the low pass filter 304 is transmitted to the amplifier 305, and the demodulator 307 receives an output signal of the amplifier 305.

The local oscillator 308 generates a frequency that allows the image rejection down-conversion mixer 303 to perform the down-conversion of the first and second RF signals into the low IF signals. The generated frequency is provided to the image rejection down-conversion mixer 303. The phase-locked loop 309 supplies a signal to the local oscillator 308 to move and lock the frequency generated by the local oscillator 308.

According to the above-described configuration, the receiver can receive frequencies at two bands and simultaneously, the SAW filter can be removed from the receiver. Thus, the receiver can be manufactured at low costs and easily integrated into a single chip.

Also, the above-described receiver configuration allows the integration of the first and second LNAs 302 and 312, the image rejection down-conversion mixer 303, the low pass filter 304, the amplifier 305, the local oscillator 308, and the phase-locked loop 309 into the single receiver chip 306.

According to the embodiment of the present invention, the first antenna 301 of the dual band T-DMB and DAB low IF receiver particularly receives a range of frequencies at the Band-III of the frequency spectrum between about 174 MHz and about 245 MHz, and the second antenna 311 thereof receives a range of frequencies at the L-band of the frequency spectrum between about 1,450 MHz and about 1,492 MHz.

Also, after the first and second antennas 301 and 311 receive the aforementioned ranges of the frequencies at the Band-III and L-band of the frequency spectrum, respectively, the dual band T-DMB and DAB low IF receiver supplies a range of frequencies between about 0.768 MHz and about 0.960 MHz as a center frequency to an output terminal of the receiver.

A band width of the frequency at the output terminal of the receiver in the present embodiment is about 1.536 MHz. A lower limit of the frequency at the output terminal of the receiver according to the present embodiment is about 0.768 MHz because a part of the frequency component at the output terminal of the receiver is likely to enter into a negative frequency region when the center frequency is about 0.768 MHz or less in the case that the band width of the frequency at the output terminal of the receiver is about 1.536 MHz.

In addition, according to the present embodiment, an upper limit of the center frequency at the output terminal of the receiver is about 0.960 MHz. The reason for setting the upper limit is because when the center frequency is about 0.960 MHz or more, undesired adjacent signals may also be comprised therein since the guard band has the minimum frequency of about 0.192 MHz or 0.176 MHz according to the specification set differently from country to country using a frequency resource.

The phase-locked loop 309 transmits the signal to the local oscillator 308 to allow the down-conversion of the received range of the signal frequencies at the Band-III or at the L-band into a range of the center frequency between about 0.768 MHz and about 0.960 MHz and the subsequent transmission of the down-converted signal to the output terminal of the receiver.

Therefore, the dual band T-DMB and DAB low IF receiver receives the signals at the two frequency bands (i.e., the Band-III and the L-band).

In the case of receiving the signal at the Band-III of the frequency spectrum, the signal goes sequentially through the first antenna 301, the first LNA 302, the image rejection down-conversion mixer 303, the low pass filter 304, and the amplifier 305. In the case of receiving the signal at the L-band of the frequency spectrum, the signal goes through the second antenna 311, the second LNA 312, the image rejection down-conversion mixer 303, the low pass filter 304, and the amplifier 305.

Particularly, the output terminal of the dual band T-DMB and DAB low IF receiver has a center frequency of about 850 kHz.

The first and second LNAs 302 and 312 and the amplifier 305 may comprise a programmable gain amplifier or a variable gain amplifier. Although not illustrated, an automatic gain controller (AGC) adjusts gains of the first and second LNAs 302 and 312 and the amplifier 205.

The demodulator 307 receives a signal from the output terminal of the receiver chip 306.

According to various embodiments of the present invention, the T-DMB and DAB low IF receiver can reduce the manufacturing costs and allow an easier implementation of the single chip integration process by being able to remove the conventional SAW filter.

According to various embodiments of the present invention, the dual band T-DMB and DAB low IF receiver can receive the signals at the two frequency bands and remove the conventional SAW filter. Thus, the manufacturing costs can be reduced, and the receiver can be easily integrated into a single chip.

The invention being thus described, it will be obvious that the same may be varied in many ways. Such variations are not to be regarded as a departure from the spirit and scope of the invention and all such modifications as would be obvious to one skilled in the art are intended to be included within the scope of the following claims.

## Claims

1. A terrestrial-digital multimedia broadcasting (T-DMB) and digital audio broadcasting (DAB) low intermediate frequency (IF) receiver comprising:
a low noise amplifier (LNA) suppressing a noise signal of a received radio frequency (RF) signal and amplifying the received RF signal, wherein the received RF signal includes a T-DMB signal or a DAB signal;
an image rejection down-conversion mixer converting a frequency band of the RF signal outputted from the LNA into a low IF band;
a low pass filter filtering a low frequency band of a signal outputted from the image rejection down-conversion mixer;
an amplifier amplifying a signal outputted from the low pass filter;
a local oscillator generating a frequency for the down-conversion and supplying the frequency to the image rejection down-conversion mixer; and
a phase-locked loop moving the frequency of the local oscillator to a certain frequency and locking the certain frequency,
wherein the LNA, the image rejection down-conversion mixer, the low pass filter, the amplifier, the local oscillator, and the phase-locked loop are integrated in a monolithic semiconductor integrated circuit substrate.

2. The T-DMB and DAB low IF receiver of claim 1, wherein the RF signal of the LNA comprises a signal at one frequency band of a Band-III ranging between about 174 MHz and about 245 MHz or an L-band ranging between about 1,450 MHz and about 1,492 MHz.

3. The T-DMB and DAB low IF receiver of claim 1, wherein the amplifier outputs a signal having a center frequency ranging from about 0.768 MHz to about 0.960 MHz.

4. The T-DMB and DAB low IF receiver of claim 1, wherein the LNA and the amplifier comprise one of a programmable gain amplifier and a variable gain amplifier.

5. A dual band terrestrial-digital multimedia broadcasting (T-DMB) and digital audio broadcasting (DAB) low intermediate frequency (IF) receiver comprising:
a first low noise amplifier (LNA) suppressing a noise signal of a received first radio frequency (RF) signal and amplifying the received first RF signal, wherein the received first RF signal includes a T-DMB signal;
a second low noise amplifier (LNA) suppressing a noise signal of a received second radio frequency (RF) signal and amplifying the received second RF signal, wherein the received second RF signal includes a DAB signal;
an image rejection down-conversion mixer converting frequency bands of the first and second RF signals respectively outputted from the first and second LNAs into a low IF band;
a low pass filter filtering a low frequency band of a signal outputted from the image rejection down-conversion mixer;
an amplifier amplifying a signal outputted from the low pass filter;
a local oscillator generating a frequency for the down-conversion and supplying the frequency to the image rejection down-conversion mixer; and
a phase-locked loop moving the frequency of the local oscillator to a certain frequency and locking the certain frequency,
wherein the first and second LNAs, the image rejection down-conversion mixer, the low pass filter, the amplifier, the local oscillator, and the phase-locked loop are integrated in a monolithic semiconductor integrated circuit substrate.

6. The dual band T-DMB and DAB low IF receiver of claim 5, wherein the first RF signal of the first LNA comprises a signal at a Band-III frequency band ranging between about 174 MHz and about 245 MHz; and the second RF signal of the second LNA comprises a signal at an L-band frequency band ranging between about 1,450 MHz and about 1,492 MHz.

7. The T-DMB and DAB low IF receiver of claim 5, wherein the amplifier outputs a signal having a center frequency ranging from about 0.768 MHz to about 0.960 MHz.

8. The T-DMB and DAB low IF receiver of claim 5, wherein the first and second LNAs and the amplifier comprise one of a programmable gain amplifier and a variable gain amplifier.
